# EUROPÄISCHE PATENTANMELDUNG

(11) **EP 4 354 734 A1**
(43) Veröffentlichungstag der Anmeldung: **17.04.2024**
(21) Anmeldenummer: 22000231.5
(22) Anmeldetag: 12.10.2022
(51) Int. Cl.: H03K 17/94

(54) **VORRICHTUNG ZUR STEUERUNG UND ANZEIGE VON GERÄTEZUSTÄNDEN EINES SCHWIMMBECKENS**

(71) Anmelder: Binder Vermögensverwaltung GmbH & Co. KG, 31789 Hameln (DE)
(72) Erfinder: Binder, Siegfried, 31787 Hameln (DE)
(74) Vertreter: Szaunig, Bernd

(57) **Zusammenfassung**

Mit der vorliegenden Erfindung wird eine Vorrichtung (1) mit einem Tastenfeld zum Betrieb einer Schwimmbeckenanlage vorgestellt, die sowohl unter Wasser als auch über Wasser Anwendung findet. Diese Vorrichtung (1) besteht im wesentlichen aus einer zumindest teilweise lichttransparenten Abdeckung (8) und einer darunter angeordneten Trägerplatine (3), die beidseitig mit elektrisch/elektronischen Bauelementen bestückt ist. Die dem Anwender zugewandte Seite der Trägerplatine (3) weist mindestens ein berührungsempfindliches Schaltelement (5) und mindestens ein Anzeigeelement (6,6') auf. Mit dem Schaltelement (5) wird mindestens ein Gerät (A, B, C) der Schwimmbeckenanlage angesteuert. Die dem Anwender abgewandte Seite der Trägerplatine (3) mit einer Mehrzahl elektronischer Bauelemente (18) ist vollständig mit einer Vergussmasse (22) vergossen, wobei die Vergussmasse mit einem besonderen Verfahren aufgebracht wird, wozu u.a. eine Ringscheibe (20) dient, die mindestens eine Ausnehmung (21) aufweist. Auf die Oberfläche der Vergussmasse (22) ist ein Ansatz (12) mit derselben Vergussmasse angegossen, wobei der Ansatz (12) unter anderem dazu dient, die Vorrichtung (1) ohne Werkzeug in einem Tubus (15) ein- und ausbauen zu können.

## Beschreibung

Die vorliegende Erfindung befasst sich mit einer Vorrichtung zur Steuerung und Anzeige von Gerätezuständen eines Schwimmbeckens, insbesondere mit einem Bedienfeld, das eine Mehrzahl von Tasten und elektronischen Bauelementen aufweist, die sowohl unter als auch über Wasser betrieben werden können. Darüber hinaus kann mit mindestens einem elektronischen Bauelement der Betriebszustand der Schwimmbeckenanlage angezeigt werden, was neben einem Komfort auch zur Betriebssicherheit der Schwimmbecken-Anlage beiträgt.

Eine derartige Vorrichtung ist im allgemeinen Stand der Technik wohl bekannt und wurde selbst von der Anmelderin dieser Patentanmeldung entwickelt. Das im allgemeinen Stand der Technik bekannte Bedienungsfeld der Vorrichtung kann im Wasser und außerhalb der Wasseroberfläche eingesetzt werden, wobei die Schaltelemente innerhalb des Bedienfeldes auf piezoelektrischem Prinzip arbeiten und somit auf das Tastenfeld bzw. auf die einzelne Taste ein geringer mechanischer Druck ausgeübt werden muss.

Weiterhin ist aus der Gebrauchsmusterschrift DE 20 2020 005 610 U1 eine Drucktaste mit einer IR-durchlässigen Abdeckung bekannt geworden, die zumindest teilweise mechanisch verformbar ist. Hinter der Abdeckung ist mindestens eine IR-Lichtquelle und mindestens ein IR-Lichtempfänger angeordnet, der IR-reflektiertes Licht empfängt und elektronisch verarbeitet. Derartige Drucktastenfelder werden beispielsweise häufig für elektrisch/elektronische Haushaltsgeräte verwendet.

Aus dem Stand der Technik ist ferner aus der DE 10 2006 049 455 A1 eine Baugruppe mit einem Tastenfeld mit mindestens einem Tastelement bekannt geworden, wobei das Tastelement auf einem Träger angeordnet ist und durch eine lichttransparente Abdeckung abgedeckt wird. Unter der Abdeckung ist auf dem Träger auch mindestens ein Lichtemitter angeordnet, der Licht durch die lichttransparente Abdeckung emittiert. Der Lichtemitter ist in unmittelbarer Nähe eines elektrischen Tastelements angeordnet. Direkt über dem Lichtemitter ist die lichttransparente Abdeckung mit einer Farbgebung eingefärbt, wobei die Einfärbung nur bei eingeschaltetem Lichtemitter sichtbar wird.

Als nachteilig wird es im Stand der Technik empfunden, dass einerseits der Aufwand zur Herstellung eines derartigen Tastenfeldes verhältnismäßig groß ist und andererseits der betriebssichere Einbau für Tastenfelder im Unterwasserbereich ungeeignet erscheint und darüber hinaus die Austauschbarkeit in einer Schwimmbeckenanlage verhältnismäßig aufwendig ist.

Daher ist es Aufgabe der vorliegenden Erfindung, eine Vorrichtung zum Betrieb einer Schwimmbeckenanlage und ein Verfahren zu dessen Herstellung bereitzustellen, die betriebssicher sowohl über Wasser als auch unter Wasser komfortable und mühelos funktioniert, sowie ohne Verwendung von Werkzeug einbaubar ist.

Diese Aufgabe wird mit den kennzeichnenden Merkmalen der Hauptansprüche gelöst.

Die erfindungsgemäße Vorrichtung zur Steuerung von Geräten, die zum Betrieb eines Schwimmbeckens dienen, ist mit einer Mehrzahl elektrischer und/oder elektronischer Bauelemente, die auf einer Trägerplatine angeordnet sind, ausgerüstet. Die Vorrichtung zeichnet sich dadurch aus, dass die elektrisch/elektronischen Bauelemente beidseitig auf einer Trägerplatine hinter einer zumindest teilweise lichttransparenten Abdeckung hermetisch abgedichtet, angeordnet sind, wobei mindestens ein elektronisches Schaltelement jeweils ein Sendeelement und mindestens ein Empfängerelement auf der dem Anwender zugewandten Seite aufweist, das hinter der lichttransparenten Abdeckung angeordnet ist.

Dabei ist es vorteilhaft, dass das Sendeelement elektromagnetische Strahlung, z.B. IR-Strahlung, abgibt, die von einem Empfängerelement bei Reflexion der Strahlung aufgenommen wird.

Ein weiterer Vorteil besteht darin, dass auf der Trägerplatine beidseitig elektrisch/elektronische Bauelemente angeordnet sind, wobei die Seite der Trägerplatine vollständig von einer Vergussmasse umgeben ist, die dem Anwender der Vorrichtung abgewandt ist.

Vorteilhaft ist es auch, dass auf der Vorderseite der Trägerplatine, also der Seite, die dem Anwender zugewandt ist, mindestens ein LED-Element angeordnet ist, das den Betriebszustand mindestens eines Gerätes zum Betrieb der Schwimmbecken-Anlage anzeigt.

Weiterhin ist es vorteilhaft, dass auf der dem Anwender zugewandten Seite der Trägerplatine mindestens ein auf Reflexion elektromagnetischer Strahlung und/oder kapazitiver, und/oder induktiver Änderung reagierendes Schaltelement angeordnet ist. Die Art und Wirkungsweise des Schaltelements ist dem jeweiligen Anwendungszweck anzupassen, zum Beispiel ist unter Wasser eine kapazitive oder induktive Wirkungsweise eher ungeeignet, während sie über Wasser durchaus geeignet sein kann.

Vorteilhaft ist es auch, dass die zumindest teilweise lichttransparente Abdeckung mindestens auf der nach innen weisenden Oberfläche mindestens eine Materialverdickung mit Lichtleitfähigkeit aufweist, wobei der Lichtleiter, bzw. die Materialverdickung Teil der Abdeckung ist.

Besonders vorteilhaft ist es für die Herstellung der Vorrichtung, dass über den Bauelementen auf der in das Innere der Vorrichtung weisenden Seite der Trägerplatine eine Ringscheibe mit mindestens einer Ausnehmung angeordnet ist, die, wie der Name sagt, ringförmig ausgebildet ist.

Ferner ist es vorteilhaft, dass auf der freien Oberfläche der Vergussmasse ein Ansatz angeordnet ist, der in einen Tubus in der Schwimmbeckenwand lösbar und ohne Zuhilfenahme von Werkzeug einsetzbar ist.

Ferner ist es vorteilhaft, dass auf der dem Anwender abgewandten Seite mit der Längsachse quer zur Oberfläche der Ringscheibe ein Hohlzylinder angeordnet ist, der zur Aufnahme einer Vergussmasse dient.

Das erfindungsgemäße Verfahren zur Herstellung einer Vorrichtung zur Steuerung von Geräten einer Schwimmbeckenanlage zeichnet sich dadurch aus, dass in einem Verfahrensschritt über die Seite einer Trägerplatine, die in das Innere der Vorrichtung weist, eine Mehrzahl elektronischer Bauelemente angeordnet wird, über die anschließend eine Ringscheibe mit mindestens einer Ausnehmung und einem Hohlzylinder angeordnet wird, um damit eine gleichmäßige Verteilung einer Vergussmasse über der dem Anwender der Vorrichtung abgewandten Seite der Trägerplatine zu gewährleisten und der Hohlzylinder zusammen mit der Vergussmasse als Einbaumittel in der Schwimmbeckenwand dient.

Dabei ist es vorteilhaft, dass im Anschluss an das Vergießen der elektronischen Bauelemente auf der in das Innere weisenden Seite der Trägerplatine, die Vergussmasse bis zu einer zähen Viskosität ausgehärtet wird.

Ein weiterer wesentlicher Verfahrensschritt zeichnet sich dadurch aus, dass in mindestens einem zweiten Verfahrensschritt ein Ansatz mit der gleichen Vergussmasse an die bereits vergossene und teilweise ausgehärtete Vergussmasse auf der Oberfläche der Trägerplatine angegossen wird, der den Hohlraum des zylinderförmigen Ansatzes auf der ringförmigen Scheibe ausfüllt, wobei mindestens ein Kabelabschnitt der elektrischen Leitungen wasserdicht mit eingegossen wird.

Weitere vorteilhafte Eigenschaften, Merkmale und Ausbildungen der vorliegenden Erfindung sind sowohl den Unteransprüchen als auch der Beschreibung zu entnehmen.

Im nun folgenden wird die Erfindung anhand von Zeichnungen im Detail näher beschrieben. Es zeigt
- Fig. 1: ein schematisches Blockschaltbild der Vorrichtung (1) mit einem Tastenfeld (2), einer Trägerplatine (3), die beidseitig (4,4') mit elektronischen Bauelementen besetzt ist und den Geräten (A, B, C) zum Betrieb einer Schwimmbecken-Anlage;
- Fig. 2: eine schematische Draufsicht auf ein Ausführungsbeispiel der dem Anwender zugewandten Seite einer Trägerplatine (3), auf der elektronische Schaltelemente (5,5'), hier nicht sichtbar, und Anzeigeelemente (6,6') angeordnet sind;
- Fig. 3: eine schematische Draufsicht auf die Innenseite einer Abdeckung (8), die über der dem Anwender zugewandten Seite einer Trägerplatine (3) angeordnet ist;
- Fig. 4: eine um 90° gegenüber der Figur 3 entgegen dem Uhrzeigersinn gedrehte schematische Querschnittsansicht der Abdeckung (8) mit lichtleitenden Materialverdickungen (9);
- Fig. 5: eine schematische Querschnittsansicht einer Vorrichtung (1), die mit einem angegossenen Ansatz (12) in einem in der Schwimmbeckenwand (13) eingebauten Tubus (15) eingesetzt ist;
- Fig. 6: eine schematische Explosionszeichnung der Vorrichtung (1) mit seinen wesentlichen Bauteilen, der Abdeckung (8), der Trägerplatine (3), der Ringscheibe (20) und der Vergussmasse (22);
- Fig. 7: eine schematische Draufsicht auf die Ringscheibe (20) mit einer Mehrzahl von Ausnehmungen (21) und einem Hohlzylinder (29), dessen Längsachse quer zur Oberfläche der Ringscheibe (20) angeordnet ist;
- Fig. 8: eine um 90° im Uhrzeigersinn gegenüber der Fig. 7 gedrehte schematische Seitenansicht der Ringscheibe (20) mit einem quer dazu angeordneten und mit Vergussmasse (22) aufgefüllten Hohlzylinder (29);
- Fig. 9: eine schematische Seitenansicht auf ein Schaltelement (5), das auf einer Trägerplatine (3) und unter einer lichttransparenten Abdeckung (8) angeordnet ist, wobei das Schaltelement (5) im wesentlichen aus mindestens einem Sendeelement (25) und mindestens aus einem Empfangselement (26) besteht.

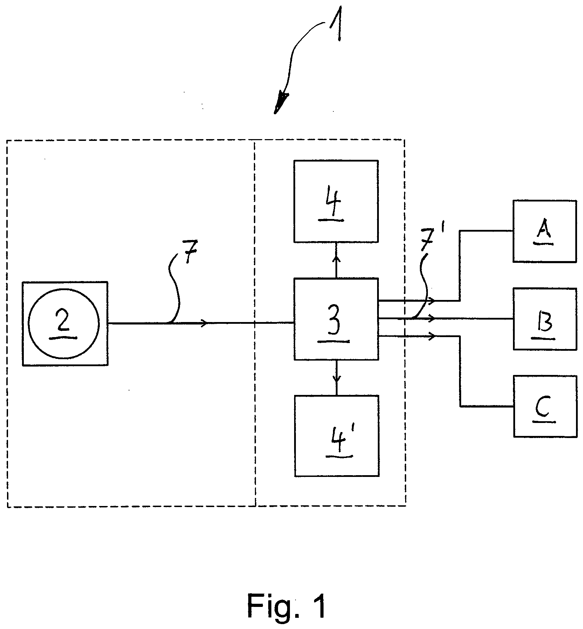

Die Fig. 1 zeigt ein schematisches Blockschaltbild der Vorrichtung 1 mit den Geräten A, B, C zum Betrieb einer Schwimmbecken-Anlage. In dieser Darstellung besteht die Vorrichtung 1 aus einem Tastenfeld 2, mit dem die Steuerung der Geräte A, B, C, zum Betrieb der Schwimmbecken-Anlage bedarfsgerecht über einen Bus 7,7' mit jeweils einem Mikroprozessor gesteuert wird, sowie einer Trägerplatine 3, die auf beiden Seiten 4,4' mit elektrisch/elektronischen Bauelementen 5,5'; 6,6'; 18 besetzt ist, wozu mindestens ein Mikroprozessor zählt. Über die Trägerplatine 3 werden die Geräte zum Betrieb der Schwimmbad-Anlage je nach Bedarf von dem Tastenfeld 2 angesteuert.

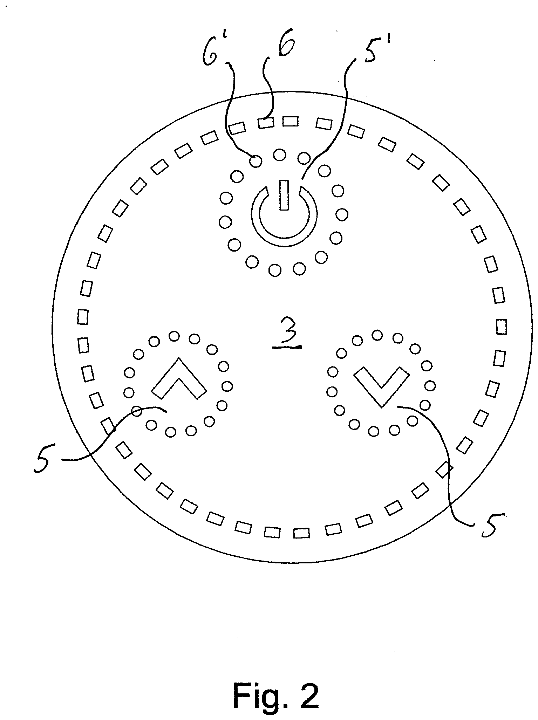

Figur 2 zeigt eine schematische Draufsicht auf eine dem Anwender zugewandten Seite eines Ausführungsbeispiels einer Trägerplatine 3, auf der beispielsweise Schaltelemente 5, 5', hier nicht gezeigt, und Anzeigeelemente 6, 6' angeordnet sind. Im vorliegenden Ausführungsbeispiel ist die Trägerplatine 3 kreisrund ausgebildet, kann aber auch in jeder anderen beliebigen, ausgewählten geometrischen Form ausgeführt werden, zum Beispiel rechteckig, dreieckig oder oval.

Im vorliegenden Ausführungsbeispiel handelt es sich um drei Schaltelemente 5, 5', von denen zwei für das Hoch- und Runterschalten eines Gerätes A oder B oder C, zum Beispiel eines Motors, der die Strömungsgeschwindigkeit einer Gegenstromanlage erzeugt, handelt und einem Ein- Ausschalter 5', der das entsprechende zu steuernde Gerät ein- und ausschaltet. Die Schaltelemente 5, 5' erzeugen ein elektrisches Signal, das einem Mikroprozessor auf der Trägerplatine 3 zugeführt wird. Die Art des Schaltelements wird weiter unten näher beschrieben. Die Schaltsymbole können linienförmig durch entsprechende Anordnung von LED-Elementen realisiert und ausgeformt werden. Die Schaltelemente 5,5' sind berührungsempfindlich ausgebildet und erzeugen bei Reflexion einer elektromagnetischen Strahlung, zum Beispiel IR-Strahlung, ein elektrisches Signal, das einem programmierten Mikroprozessor zugeführt wird. Das Ein- und Ausschaltsymbol 5' besteht z.B. aus einem aus passenden LEDs zusammengefügten Kreis, der durch einen senkrechten Strich unterbrochen ist; oder zwei Pfeilspitzen, bei der die eine Spitze sinngebend nach oben zeigt und die andere nach unten. Um die Schaltelemente 5, 5' herum sind ferner kreisförmig farbige LED-Leuchten angeordnet, die bei Betätigung des jeweiligen Schaltelements 5,5' leuchten, um damit dem Anwender zu signalisieren, dass eine Schaltfunktion eines Gerätes A, B, C ausgeübt wird.

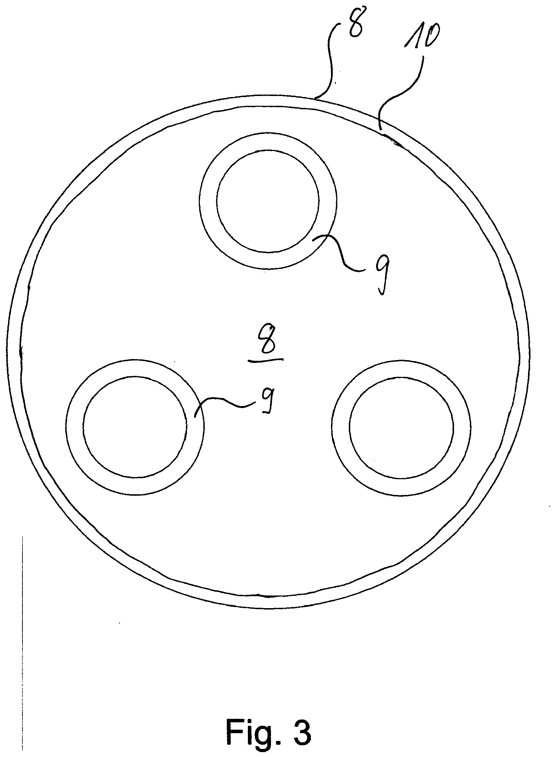

Die Figur 3 zeigt eine schematische Draufsicht auf die Rückseite einer topfförmigen Abdeckung 8, die über der dem Anwender zugewandten Seite der Trägerplatine 3 angeordnet ist. Die Abdeckung 8 überdeckt die Trägerplatine 3 vollständig und ist daher der Form der Trägerplatine 3 angepasst, also rund. Das Material der Abdeckung 8 ist zumindest an vorbestimmten Stellen lichttransparent, sodass an diesen Stellen der Abdeckung 8 eine elektromagnetische Strahlung, zum Beispiel IR-Strahlung, austreten und durch Reflexion an Körperteilen, wie Finger, wieder in die Vorrichtung 1 eintreten kann, wo sie von einem Empfängerelement 26 aufgenommen wird. An den Stellen der Abdeckung 8, unter denen die Schaltelemente 5,5' und die die Schaltelemente umgebende Anzeigeelemente 6' auf der Trägerplatine 3 angeordnet sind, sind im vorliegenden Ausführungsbeispiel kreisrunde Material-Verdickungen 9 angeordnet, wobei die Material-Verdickungen 9 lichtleitende Eigenschaften aufweisen und aus der Ebene der Rückseite der Abdeckung 8 heraustreten. Dadurch entsteht ein besonderer Lichteffekt für den Betrachter, wenn ein auf der Trägerplatine 3 angeordnete vorbestimmte LED-Leuchte aktiviert wird.

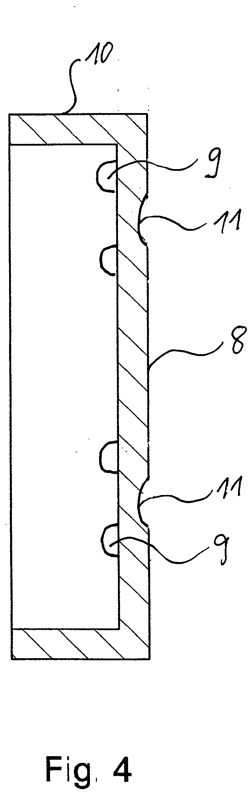

Die Figur 4 zeigt eine um 90° entgegen dem Uhrzeigersinn gedrehte schematische Seitenansicht der Abdeckung 8 aus Figur 3. Die Abdeckung 8 ist im Querschnitt topfförmig ausgebildet und weist an den Rändern der Oberfläche eine Abkantung 10 auf, die einerseits dazu dient, einer Vergussmasse 22, auf der dem Anwender abgewandten Seite der Trägerplatine 3 einen Rahmen zu bieten und andererseits ein Befestigungsmittel der Abdeckung 8 darstellt. Die Material- Verdickungen 9 treten aus der Ebene der Oberfläche der Rückseite der Abdeckung 8 heraus, womit der Anwender einerseits darauf hingewiesen wird, an welcher Stelle der Abdeckung 8 er genau den Finger zu setzen hat, um ein Schaltsignal zu erzeugen; und andererseits haben die Materialverdickungen 9 auch Infolge ihrer Lichtleitfähigkeit eine optische Wirkung, weil die Materialverdickungen 9 praktisch einen Lichtleiter bilden, der eintretendes Licht in bestimmte Bahnen lenkt, die für den Anwender sichtbar als bestimmte Symbole wahrgenommen werden. An der Außenseite der Abdeckung 8 kann im Bereich der Material Verdickungen 9 in die Oberfläche eine Vertiefung oder Mulde 11 eingelassen werden, die die haptischen Eigenschaften der Abdeckungsoberfläche für den Anwender unterstützt und als angenehm und hilfreich empfunden wird.

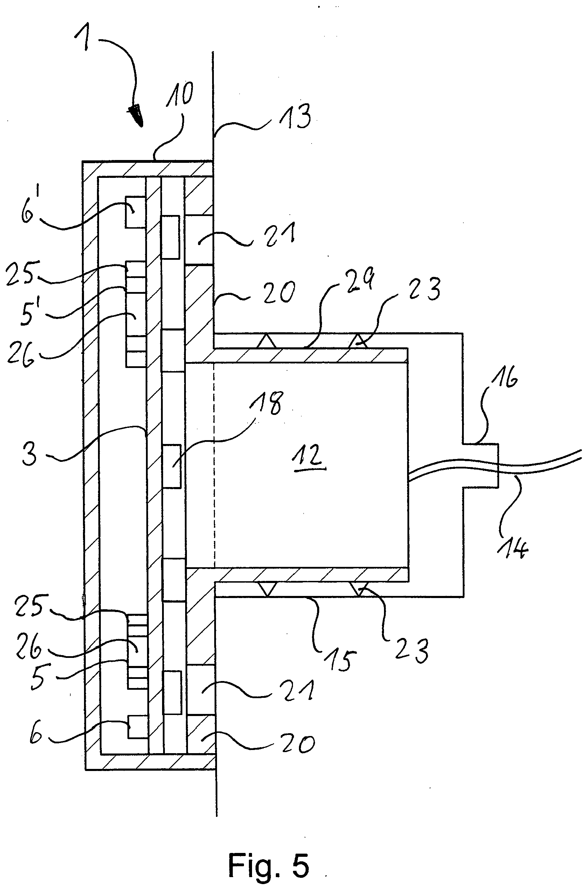

Die Figur 5 zeigt eine schematische Querschnittsansicht der Vorrichtung 1, die mit einem angegossen Ansatz 12 und einen Hohlzylinder 29 in einem in der Schwimmbeckenwand 13 eingebauten Tubus 15 eingesetzt ist. Am hinteren Ende des Tubus 15 ist eine Kabel-Durchführung 16 angeordnet, durch die die elektrischen Leitungen bzw. das Kabel 14 wasserdicht durchgeführt wird.

Wie bereits weiter oben erwähnt, ist über der dem Anwender zugewandten Seite der Trägerplatine 3 eine Abdeckung 8 angeordnet. Auf der dem Anwender zugewandten Seite der Trägerplatine 3 sind die Schaltelemente 5,5' und verschiedene Anzeigeelemente 6, 6' angeordnet, die meistens als LED-Leuchten ausgebildet sind. Das Schaltelement besteht im vorliegenden Ausführungsbeispiel aus einer IR-Strahlung erzeugenden Element 25 und einem IR-Strahlung empfangenden Element 26, das die am Finger einer bedienenden Person reflektierte IR-Strahlung aufnimmt. Die Schaltelemente 5,5' und die Anzeigeelemente 6,6' auf der Trägerplatte 3 sind von einer sauerstoffarmen und trockenen Atmosphäre umgeben, um damit die Langlebigkeit der Trägerplatine 3 zu unterstützen.

Auf der dem Anwender abgewandten Seite der Trägerplatine 3 sind elektronische Bauelemente 18, wie beispielsweise ein Mikroprozessor, angeordnet, die die Signalverarbeitung der von den Schaltelementen 5,5' erzeugten Signale durchführen und sie über den Bus 7' den einzelnen Geräten zum Betrieb der Schwimmbeckenanlage zuführen.

Über den elektronischen Bauelementen 18 auf der Rückseite der Trägerplatine 3 ist eine Ringscheibe 20 angeordnet, die mindestens eine Ausnehmung 21 aufweist, um beim Vergießen der Vergussmasse 22 eine gleichmäßige Verteilung der Vergussmasse zu gewährleisten. Die Vergussmasse 22 erstreckt sich bis zur Abkantung 10 der Abdeckung 8 über die gesamte Fläche der Trägerplatine 3. Auf die Oberfläche der Vergussmasse 22 ist in einem besonderen Verfahrensschritt ein Ansatz 12 aus derselben Vergussmasse angegossen. Der Ansatz 12 ragt in den Tubus 15 in der Schwimmbeckenwand 13 hinein. Im vorliegenden Ausführungsbeispiel ist der Ansatz 12 zylinderförmig ausgebildet und weist an seinen Mantelflächen elastische Sicherungselemente 23 auf, die dazu dienen, die gesamte Vorrichtung 1 mühelos an den Wänden des Tubus 15 lösbar zu befestigen, bzw. auszuwechseln.

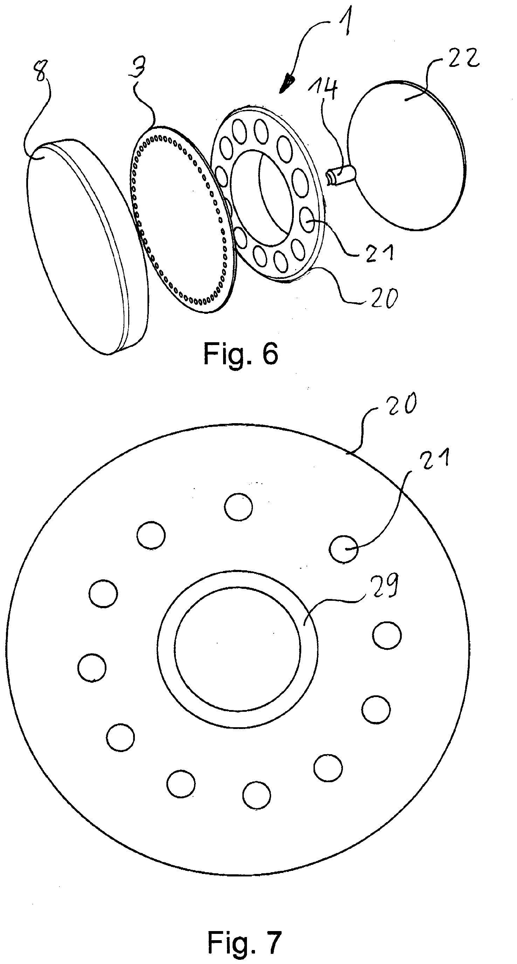

Die Figur 6 zeigt eine Explosionszeichnung der Vorrichtung 1 mit den wesentlichen Bauteilen wie die Abdeckung 8, die Trägerplatine 3, die Ringscheibe 20 und die Vergussmasse 22, die alle an anderer Stelle näher im Detail beschrieben werden, insbesondere die Ringscheibe 20 und deren Funktion.

Die Figur 7 zeigt eine schematische Draufsicht auf die Ringscheibe 20 mit einer Mehrzahl von Ausnehmungen 21, die unter anderem dazu dienen, die Vergussmasse 22 beim Vergießen gleichmäßig über die gesamte Fläche der Trägerplatine 3 zu verteilen. Die Ringscheibe 20 besteht aus einem geeigneten Kunststoff, der sowohl temperaturbeständig ist, als auch eine ausreichende mechanische Stabilität aufweist. Die Ringscheibe ist als Kreisring ausgebildet, die sich über die gesamte Oberfläche auf der dem Anwender abgewandten Seite der Trägerplatine 3 erstreckt.

Am Ende des ersten Abschnitts des Vergiessvorgangs quillt die Vergussmasse 22 in die Ausnehmungen 21 hinein, bis sie den oberen Rand der mindestens einen Ausnehmung 21 erreicht hat. Damit baut die Ringscheibe 20 einen leichten hydrostatischen Druck auf die Vergussmasse 22 aus, wodurch eine gleichmäßige Verteilung der Vergussmasse 22 über die gesamte Fläche der dem Anwender der Vorrichtung 1 abgewandten Seite der Trägerplatine 3 gewährleistet wird. Somit werden die elektronischen Bauelemente 18 vollständig einschlussfrei von der Vergussmasse 22 umgeben. Bei diesem Vorgang wird zunächst die Vergussmasse 22 in Pfeilrichtung durch den Hohlraum des Hohlzylinders 29 der Ringscheibe 20 auf die Oberfläche der vom Anwender abgewandten Seite der Trägerplatine 3 vergossen, bis die Vergussmasse 22 den oberen Rand der Ausnehmungen 21 erreicht hat, nachdem die einzelnen Bauteile 8,3,20,22 in ihre endgültige Position gebracht worden sind.

Als weiterer wesentlicher Verfahrensschritt wird dann die aufgegossene flüssige Vergussmasse 22 bis zu einem vorgegebenen Härtegrad ausgehärtet. Im Anschluss daran wird in einem weiteren Verfahrensschritt erneut die gleiche flüssige Vergussmasse 22 in den Hohlzylinder 29 eingefüllt, bis der Hohlraum des Hohlzylinders 29 randvoll aufgefüllt ist. Dabei wird gleichzeitig ein Teil des die elektrischen Leitungen zusammenfassenden Kabels 14 wasserdicht mit eingegossen. Das gesamte Verfahren wird schließlich durch Aushärtung der gesamten Vergussmasse abgeschlossen.

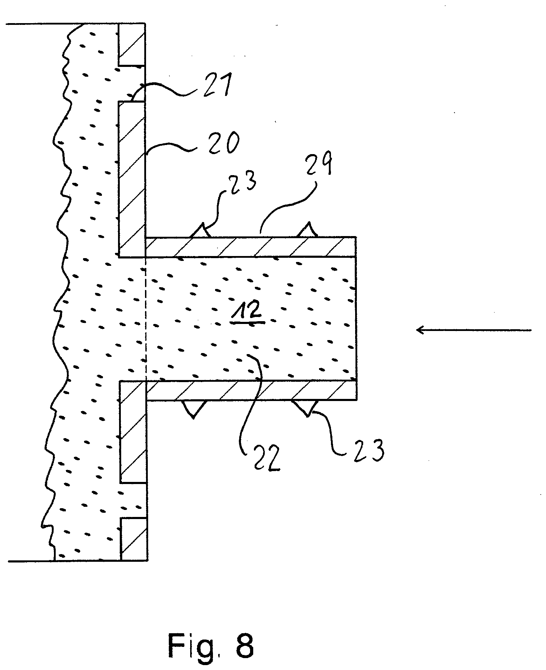

Die Figur 8 zeigt eine im Uhrzeigersinn um 90° gegenüber der Figur 7 gedrehte schematische Seitenschnittansicht der Ringscheibe 20 mit einem quer dazu angeordneten und mit Vergussmasse 22 aufgefüllten Hohlzylinder 29. Der Hohlzylinder bildet praktisch einen Aufsatz auf die Ringscheibe 20, quer zur Oberfläche der Ringscheibe. Die Wände des Hohlzylinders 29 bilden somit die Begrenzung für die Vergussmasse 22, die im Laufe des Herstellungsprozesses der Vorrichtung 1 eingegossen wird. Auf der äußeren Oberfläche des Hohlzylinders 29 sind elastische Sicherungselemente 23 angeordnet, die dazu dienen, die Vorrichtung 1 in dem Tubus 15 in der Schwimmbeckenwand 13 lösbar zu befestigen.

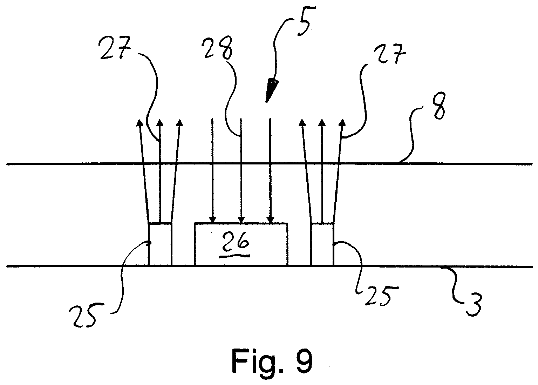

Die Figur 9 zeigt eine schematische Seitenansicht auf ein Schaltelement 5 auf einer Trägerplatine 3, unterhalb einer lichttransparenten Abdeckung 8, wobei das Schaltelement 5 im wesentlichen aus mindestens einem Sendeelement 25 und mindestens aus einem Empfangselement 26 besteht. Von dem mindestens einen Sendeelement 25 wird eine elektromagnetische IR-Strahlung 27 gesendet, die die lichttransparente Abdeckung 8 durchdringt. Bei Annäherung eines Fingers des menschlichen Körpers in den Strahlungsbereich des Sendeelements 25 wird die elektromagnetische Strahlung 27 zumindest teilweise an der Oberfläche des Fingers reflektiert. Diese reflektierte IR-Strahlung 28 wird somit von mindestens einem Empfängerelement 26 aufgenommen, das ein elektrisches Signal erzeugt, das wiederum einem Mikroprozessor zur weiteren Analyse und Verarbeitung zugeführt wird. Damit muss der Anwender keine mechanische Kraft aufwenden, um das elektronische Schaltelement 5 zu bedienen. Anstatt eines derartig beschriebenen Schaltelements, das auf Reflexion elektromagnetischer Strahlung basiert, kann unter bestimmten Voraussetzungen auch ein elektronisches Schaltelement herangezogen werden, dass auf kapazitive oder induktive Änderungen bei Annäherung eines Fingers an die Schaltfläche des Tastenfeldes 2 reagiert.

Zusammenfassend darf festgestellt werden, dass mit der vorliegenden Erfindung eine Vorrichtung 1 mit einem Tastenfeld zum Betrieb einer Schwimmbeckenanlage vorgestellt wird, die sowohl unter Wasser als auch über Wasser Anwendung findet. Diese Vorrichtung 1 besteht im wesentlichen aus einer zumindest teilweise lichttransparenten Abdeckung 8 und einer darunter angeordneten Trägerplatine 3, die beidseitig mit elektrisch/elektronischen Bauelementen bestückt ist. Die dem Anwender zugewandte Seite der Trägerplatine 3 weist mindestens ein berührungsempfindliches Schaltelement 5 und mindestens ein Anzeigeelement 6,6' auf. Mit dem Schaltelement 5 wird mindestens ein Gerät A, B oder C der Schwimmbeckenanlage angesteuert. Die dem Anwender abgewandte Seite der Trägerplatine 3 mit einer Mehrzahl elektronischer Bauelemente 18 ist vollständig mit einer Vergussmasse 22 vergossen, wobei die Vergussmasse mit einem besonderen Verfahren aufgebracht wird, wozu u.a. eine Ringscheibe 20 dient, die mindestens eine Ausnehmung 21 aufweist. Auf die Oberfläche der Vergussmasse 22 ist ein Ansatz 12 mit derselben Vergussmasse angegossen, wobei der Ansatz 12 unter anderem dazu dient, die Vorrichtung 1 ohne Werkzeug in einem Tubus 15 ein- und ausbauen zu können.

## Patentansprüche

1. Vorrichtung (1) mit einem Tastenfeld (2) zur Steuerung von Geräten (A, B, C) zum Betrieb eines Schwimmbeckens, wobei die Vorrichtung (1) eine Trägerplatine (3) mit einer Mehrzahl elektrischer und/oder elektronischer Bauelemente (18) aufweist, **gekennzeichnet durch** Schaltelemente (5,5') und Anzeigeelemente (6,6'), sowie Bauelemente (18), die hermetisch abgedichtet hinter einer lichttransparenten Abdeckung (8) angeordnet sind, wobei mindestens ein Schaltelement (5,5') jeweils mindestens ein Sendeelement (25) und mindestens ein Empfängerelement (26) aufweist.

2. Vorrichtung nach Anspruch 1, **dadurch gekennzeichnet, dass** das Sendeelement (25) elektromagnetische Wellen ausstrahlt, die von dem Empfängerelement (26) bei Reflexion der Strahlung aufgenommen werden.

3. Vorrichtung nach Anspruch 1 und/oder 2, **dadurch gekennzeichnet, dass** auf der Trägerplatine (3) beidseitig die elektrisch/elektronischen Schaltelemente (5,5') und Anzeigeelemente (6,6') und Bauelemente (18) angeordnet sind.

4. Vorrichtung nach einem der vorangegangenen Ansprüche, **dadurch gekennzeichnet, dass** auf der dem Anwender zugewandten Seite der Trägerplatine (3) mindestens ein LED-Element (6,6') angeordnet ist, das den Betriebszustand mindestens eines Gerätes (A, B, C) zum Betrieb der Schwimmbecken-Anlage anzeigt.

5. Vorrichtung nach einem der vorangegangenen Ansprüche, **dadurch gekennzeichnet, dass** auf der dem Anwender zugewandten Seite der Trägerplatine (3) mindestens ein auf Reflexion elektromagnetischer Strahlung reagierendes Schaltelement (5,5') angeordnet ist.

6. Vorrichtung nach einem der vorangegangenen Ansprüche, **dadurch gekennzeichnet, dass** die mindestens teilweise lichttransparente Abdeckung (8) mindestens auf der nach innen weisenden Oberfläche mindestens eine Materialverdickung (9) mit Lichtleitfähigkeit aufweist.

7. Vorrichtung nach einem der vorangegangenen Ansprüche, **dadurch gekennzeichnet, dass** die elektronischen Bauelemente (18) auf der Trägerplatine (3) auf der nach innen weisenden Oberfläche der Trägerplatine (3) von einer Vergussmasse (22) umgeben sind, in die eine Ringscheibe (20) mit mindestens einer Ausnehmung (21) eingegossen ist.

8. Vorrichtung nach einem der vorangegangenen Ansprüche, **dadurch gekennzeichnet, dass** auf der freien Oberfläche der Vergussmasse (22) ein Ansatz (12) angeordnet ist, der zusammen mit dem Hohlzylinder (29) in einen Tubus (15) in der Schwimmbeckenwand (13) lösbar ohne Zuhilfenahme von Werkzeug einsetzbar ist.

9. Vorrichtung nach einem der vorangegangenen Ansprüche, **dadurch gekennzeichnet, dass** mindestens ein LED-Element (6,6') auf der dem Anwender zugewandten Seite der Trägerplatine (3) angeordnet ist, das mindestens einen Betriebszustand der Schwimmbeckenanlage anzeigt.

10. Verfahren zur Herstellung einer Vorrichtung (1) zur Steuerung von Geräten (A, B, C), die dem Betrieb eines Schwimmbeckens dienen, **dadurch gekennzeichnet, dass** in einem Verfahrensschritt über der dem Anwender abgewandten Seite einer Trägerplatine (3), eine Ringscheibe (20) angeordnet wird, die mindestens eine Ausnehmung (21) aufweist, um damit eine gleichmäßige Verteilung einer Vergussmasse (22) zu gewährleisten.

11. Verfahren nach Anspruch 10, **gekennzeichnet durch** mindestens zwei Verfahrensschritte, wobei in einem vorangehenden Verfahrensschritt die dem Anwender abgewandte Seite der Trägerplatine (3) zusammen mit der Ringscheibe (20) mit einer geeigneten Vergussmasse (22) gleichmäßig bis zu einem vorbestimmten Niveau vergossen wird.

12. Verfahren nach einem der vorangegangenen Ansprüche, **dadurch gekennzeichnet, dass** im Anschluss an den einen vorangehenden Verfahrensschritt des Vergießens die Vergussmasse (22) bis zu einer zähen Viskosität ausgehärtet wird.

13. Verfahren nach einem der vorangegangenen Ansprüche, **dadurch gekennzeichnet, dass** in mindestens einem weiteren anschließenden Verfahrensschritt ein Ansatz (12) mit der gleichen Vergussmasse (22) angegossen wird, wobei mindestens ein Kabelabschnitt der elektrischen Leitungen (14) wasserdicht mit eingegossen wird.
